# EUROPEAN PATENT APPLICATION

(11) **EP 4 510 170 A1**
(43) Date of publication of application: **19.02.2025**
(21) Application number: 22937398.0
(22) Date of filing: 13.04.2022

(54) **JOSEPHSON JUNCTION ELEMENT, QUANTUM DEVICE, AND PRODUCTION METHOD FOR JOSEPHSON JUNCTION ELEMENT**

(71) Applicant: FUJITSU LIMITED, Kawasaki-shi, Kanagawa 211-8588 (JP)
(72) Inventor: NAKAMURA, Makoto, Kawasaki-shi, Kanagawa 211-8588 (JP)
(74) Representative: Haseltine Lake Kempner LLP
(86) International application number: PCT/JP2022/017665
(87) International publication number: WO 2023/199419

(57) **Abstract**

A Josephson junction device includes: a first superconducting film; a first insulating film provided over the first superconducting film; and a second superconducting film provided over the first insulating film, in which a surface layer portion of the first insulating film includes: a first region; and a second region around the first region, electrical insulation properties of the first region are higher than the electrical insulation properties of the second region, and the second superconducting film is located at an inner side of a boundary between the first region and the second region in plan view.

## Description

### TECHNICAL FIELD

The present disclosure relates to a Josephson junction device, a quantum device, and a method for manufacturing the Josephson junction device.

### BACKGROUND ART

Application of a qubit including a Josephson junction device to a quantum computer has been studied. The Josephson junction device includes two superconducting films and an insulating film between the two superconducting films.

### CITATION LIST

### PATENT DOCUMENT

Patent Document 1: U.S. Patent Application Publication No. 2017/0179193
Patent Document 2: Japanese Laid-open Patent Publication No. 62-213287
Patent Document 3: Japanese Laid-open Patent Publication No. 5-145132
Patent Document 4: U.S. Patent Application Publication No. 2014/0357493

### SUMMARY OF INVENTION

### TECHNICAL PROBLEM

Conventionally, one superconducting film included in a Josephson junction device is processed by reactive ion etching after film formation, and damage inevitably occurs in the vicinity of a side surface of the superconducting film remaining after the processing. When damage occurs in the superconducting film, properties of the Josephson junction between a region where this damage has occurred and the other superconducting film can vary. Furthermore, at the time of reactive ion etching on the superconducting film, damage inevitably occurs also in the insulating film. Also in a case where the Josephson junction includes a region of the insulating film where damage has occurred, the properties of the Josephson junction can vary.

An object of the present disclosure is to provide a Josephson junction device, a quantum device, and a method for manufacturing the Josephson junction device capable of obtaining stable properties.

### SOLUTION TO PROBLEM

According to one form of the present disclosure, there is provided a Josephson junction device including: a first superconducting film; a first insulating film provided over the first superconducting film; and a second superconducting film provided over the first insulating film, in which a surface layer portion of the first insulating film includes a first region and a second region around the first region, electrical insulation properties of the first region are higher than the electrical insulation properties of the second region, and the second superconducting film is located at an inner side of a boundary between the first region and the second region in plan view.

### ADVANTAGEOUS EFFECTS OF INVENTION

According to the present disclosure, stable properties may be obtained.

### BRIEF DESCRIPTION OF DRAWINGS

FIG. 1 is a cross-sectional view illustrating a Josephson junction device according to a first embodiment.
FIG. 2 is a plan view illustrating the Josephson junction device according to the first embodiment.
FIG. 3 is a cross-sectional view (part 1) illustrating a method for manufacturing the Josephson junction device according to the first embodiment.
FIG. 4 is a cross-sectional view (part 2) illustrating the method for manufacturing the Josephson junction device according to the first embodiment.
FIG. 5 is a cross-sectional view (part 3) illustrating the method for manufacturing the Josephson junction device according to the first embodiment.
FIG. 6 is a cross-sectional view (part 4) illustrating the method for manufacturing the Josephson junction device according to the first embodiment.
FIG. 7 is a cross-sectional view (part 5) illustrating the method for manufacturing the Josephson junction device according to the first embodiment.
FIG. 8 is a cross-sectional view (part 6) illustrating the method for manufacturing the Josephson junction device according to the first embodiment.
FIG. 9 is a cross-sectional view (part 7) illustrating the method for manufacturing the Josephson junction device according to the first embodiment.
FIG. 10 is a cross-sectional view (part 8) illustrating the method for manufacturing the Josephson junction device according to the first embodiment.
FIG. 11 is a cross-sectional view (part 9) illustrating the method for manufacturing the Josephson junction device according to the first embodiment.
FIG. 12 is a cross-sectional view (part 10) illustrating the method for manufacturing the Josephson junction device according to the first embodiment.
FIG. 13 is an enlarged cross-sectional view illustrating a part of FIG. 1.
FIG. 14 is a cross-sectional view illustrating a portion corresponding to the Josephson junction device in FIG. 13 according to a reference example.
FIG. 15 is a cross-sectional view illustrating a Josephson junction device according to a second embodiment.
FIG. 16 is a plan view illustrating the Josephson junction device according to the second embodiment.
FIG. 17 is a cross-sectional view (part 1) illustrating a method for manufacturing the Josephson junction device according to the second embodiment.
FIG. 18 is a cross-sectional view (part 2) illustrating the method for manufacturing the Josephson junction device according to the second embodiment.
FIG. 19 is a cross-sectional view (part 3) illustrating the method for manufacturing the Josephson junction device according to the second embodiment.
FIG. 20 is a cross-sectional view (part 4) illustrating the method for manufacturing the Josephson junction device according to the second embodiment.
FIG. 21 is a cross-sectional view (part 5) illustrating the method for manufacturing the Josephson junction device according to the second embodiment.
FIG. 22 is a cross-sectional view (part 6) illustrating the method for manufacturing the Josephson junction device according to the second embodiment.
FIG. 23 is a cross-sectional view (part 7) illustrating the method for manufacturing the Josephson junction device according to the second embodiment.
FIG. 24 is a cross-sectional view (part 8) illustrating the method for manufacturing the Josephson junction device according to the second embodiment.
FIG. 25 is a cross-sectional view (part 9) illustrating the method for manufacturing the Josephson junction device according to the second embodiment.
FIG. 26 is a cross-sectional view (part 10) illustrating the method for manufacturing the Josephson junction device according to the second embodiment.
FIG. 27 is a diagram illustrating a quantum device according to a third embodiment.

### DESCRIPTION OF EMBODIMENTS

Hereinafter, embodiments of the present disclosure will be specifically described with reference to the accompanying drawings. Note that, in the present description and the drawings, constituent elements having substantially the same functional configuration will be denoted by the same reference sign, and redundant explanation will sometimes not be made.

### (First Embodiment)

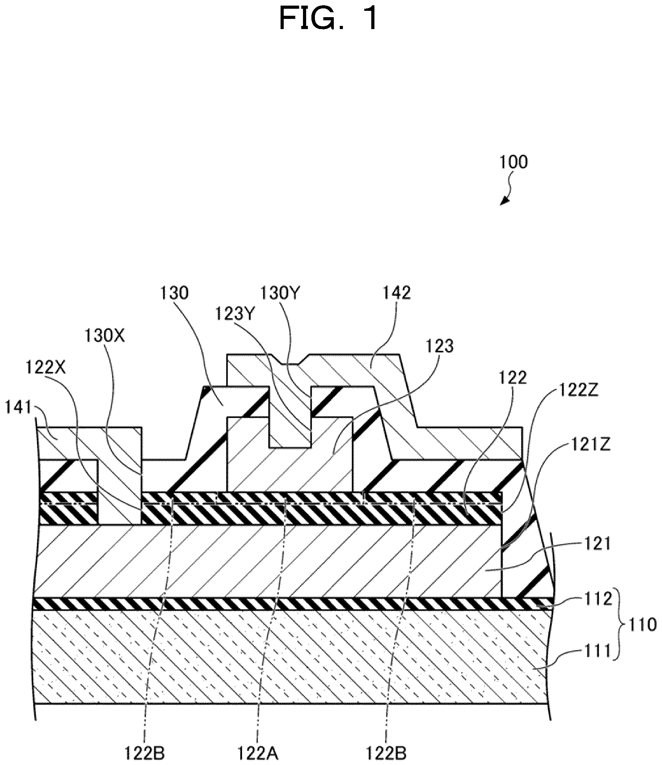

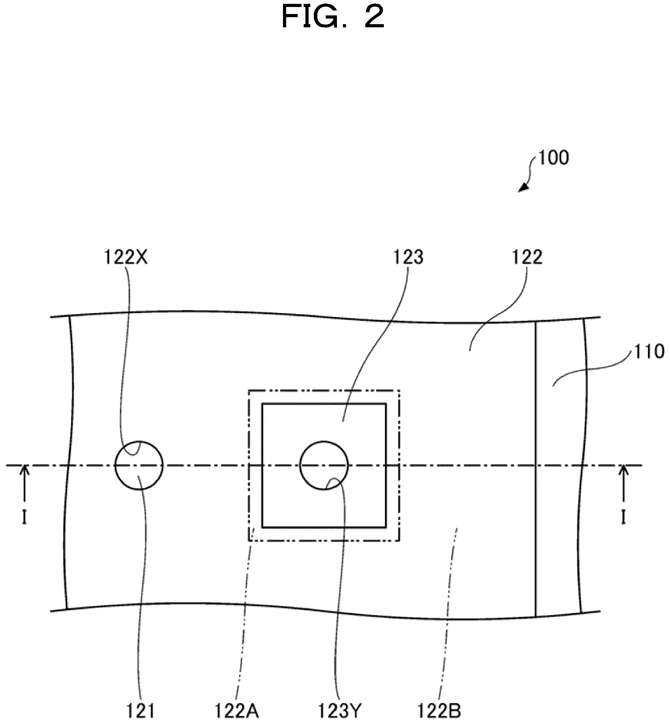

First, a first embodiment is described. The first embodiment relates to a Josephson junction device. FIG. 1 is a cross-sectional view illustrating a Josephson junction device according to the first embodiment. FIG. 2 is a plan view illustrating the Josephson junction device according to the first embodiment. FIG. 1 corresponds to a cross-sectional view taken along line I-I in FIG. 2. In FIG. 2, a wire line 141, a wire line 142, and an insulating film 130 are omitted.

As illustrated in FIGs. 1 and 2, a Josephson junction device 100 according to the first embodiment mainly includes a substrate 110, a superconducting film 121, an insulating film 122, a superconducting film 123, the insulating film 130, the wire line 141, and the wire line 142.

The substrate 110 includes, for example, a silicon (Si) substrate 111 and an insulating film 112. The insulating film 112 is formed over the silicon substrate 111. The insulating film 112 is, for example, a silicon oxide film. The substrate 110 is a so-called oxide film-attached substrate. The superconducting film 121 is provided over the insulating film 112. The superconducting film 121 is, for example, a niobium (Nb) film having a thickness of about 200 nm. The insulating film 122 is provided over the superconducting film 121. The insulating film 122 is, for example, an aluminum oxide (Al) film having a thickness of about 20 nm. The superconducting film 123 is provided over the insulating film 122. The superconducting film 123 is, for example, a niobium film having a thickness of about 200 nm. The superconducting film 121 is an example of a first superconducting film, the insulating film 122 is an example of a first insulating film, and the superconducting film 123 is an example of a second superconducting film.

A surface layer portion of the insulating film 122 includes a first region 122A and a second region 122B around the first region 122A. Greater damage has occurred in the second region 122B than the first region 122A, and the electrical insulation properties of the second region 122B are lower than the electrical insulation properties of the first region 122A. That is, the electrical insulation properties of the first region 122A are higher than the electrical insulation properties of the second region 122B. The superconducting film 123 is provided over the first region 122A. In plan view, the superconducting film 123 is located at an inner side of a boundary between first region 122A and second region 122B. The magnitude of damage in the first region 122A and the second region 122B can be specified using, for example, a transmission electron microscope (TEM). In other words, in TEM observation, since the phase contrast is different between a region with great damage and a region with small damage, the first region 122A and the second region 122B can be distinguished from each other.

A groove 121Z is formed in the superconducting film 121, and a groove 122Z is formed in the insulating film 122. The groove 122Z communicates with the groove 121Z, and the insulating film 112 is exposed through the grooves 121Z and 122Z. The grooves 121Z and 122Z are, for example, grooves for device separation. The insulating film 130 covers the substrate 110, the superconducting film 121, the insulating film 122, and the superconducting film 123. The insulating film 130 is, for example, a silicon oxide film.

A contact hole 122X is formed in the insulating film 122, and a contact hole 130X is formed in the insulating film 130. The contact hole 130X communicates with the contact hole 122X, and the superconducting film 121 is exposed through the contact holes 122X and 130X. The contact hole 122X passes through the second region 122B, for example. The wire line 141 is provided over the insulating film 130 and also is in contact with the superconducting film 121 through the contact holes 122X and 130X. The wire line 141 is, for example, a niobium film.

A contact hole 130Y is formed in the insulating film 130. The superconducting film 123 is exposed through the contact hole 130Y. A recess 123Y communicating with the contact hole 130Y may be formed on a surface of the superconducting film 123. The wire line 142 is provided over the insulating film 130 and also is in contact with the superconducting film 123 through the contact hole 130Y. The wire line 142 is, for example, a niobium film.

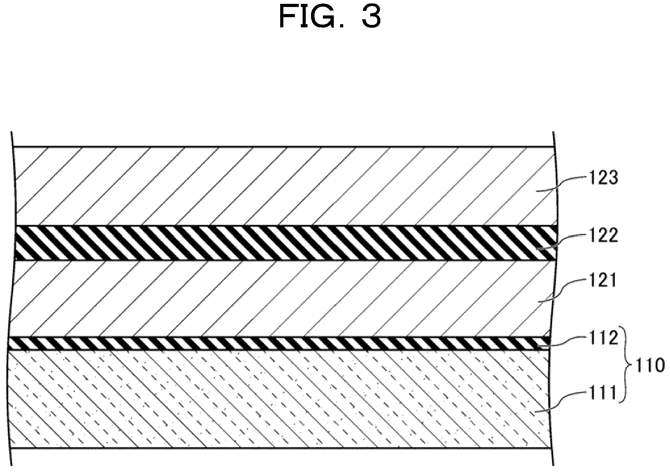

Next, a method for manufacturing the Josephson junction device 100 according to the first embodiment will be described. FIGs. 3 to 12 are cross-sectional views illustrating a method for manufacturing the Josephson junction device according to the first embodiment.

First, as illustrated in FIG. 3, the substrate 110 including the silicon substrate 111 and the insulating film 112 is prepared, and the superconducting film 121, the insulating film 122, and the superconducting film 123 are formed over the insulating film 112.

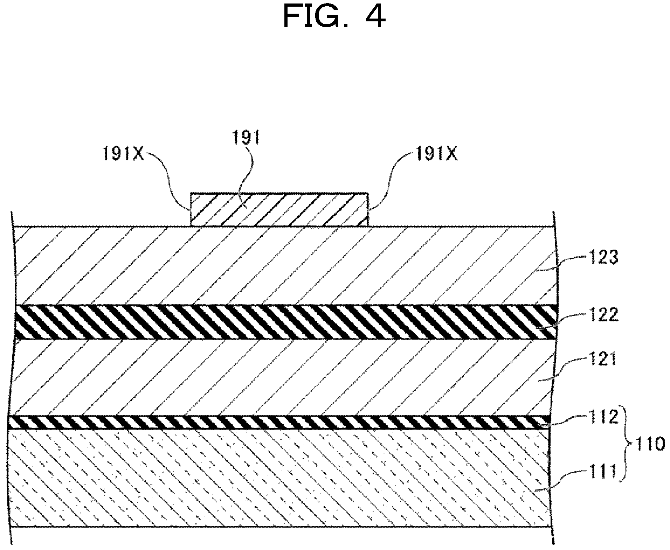

Next, as illustrated in FIG. 4, a resist pattern 191 is formed over the superconducting film 123. The resist pattern 191 includes an opening 191X. In plan view, the opening 191X approximately overlaps a region where the second region 122B of the insulating film 122 is to be formed.

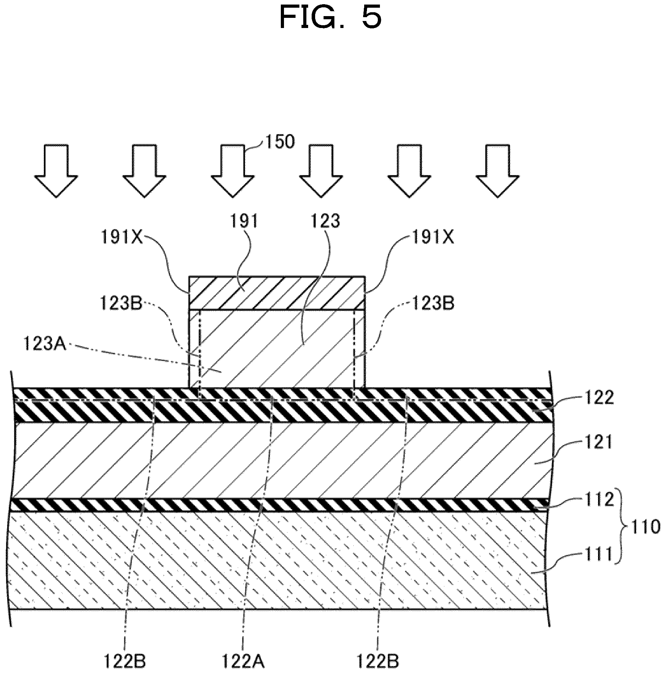

Thereafter, as illustrated in FIG. 5, the superconducting film 123 is etched with the resist pattern 191 as a mask. This etching is, for example, reactive ion etching (RIE) using a reactive gas 150 containing sulfur hexafluoride (SF₆) as a main component. This etching is performed until the insulating film 122 is exposed. As a result, a portion of the superconducting film 123 covered with the resist pattern 191 remains. A vicinity of a side surface of the remaining superconducting film 123 is damaged by etching, and a damaged region 123B is formed in the vicinity of the side surface of the superconducting film 123. The superconducting film 123 has an internal region 123A not damaged by etching on an inner side of the damaged region 123B. In addition, a vicinity of an upper surface of the insulating film 122 is also damaged by etching, and the first region 122A and the second region 122B around the first region 122A are formed in a surface layer portion of the insulating film 122. In the second region 122B, etching damage greater than the etching damage in the first region 122A has occurred, and the electrical insulation properties of the second region 122B becomes lower than the electrical insulation properties of the first region 122A. The first region 122A is formed at an inner side of an outer edge of the resist pattern 191 in plan view.

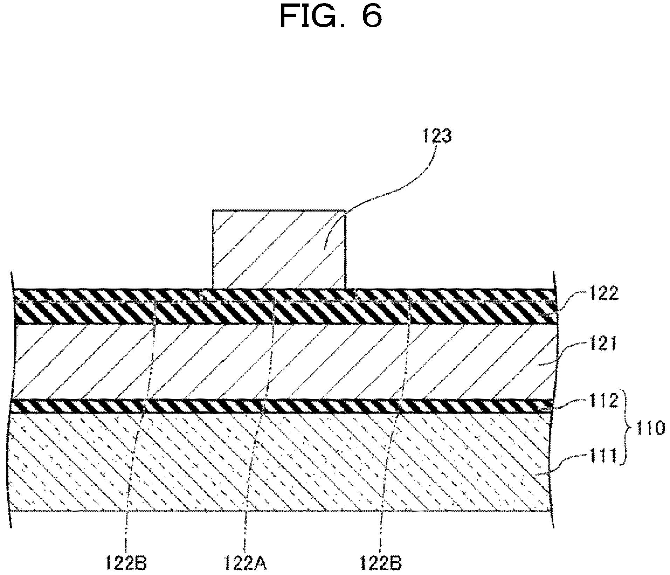

Subsequently, as illustrated in FIG. 6, the resist pattern 191 is removed. Next, the damaged region 123B is removed by etching the superconducting film 123. This etching is, for example, isotropic etching such as wet etching. For example, the superconducting film 123 is etched by about 20 nm in a direction parallel to a surface of the substrate 110. That is, the superconducting film 123 is reduced in plan view by isotropic etching. As a result, the superconducting film 123 is positioned over the first region 122A and is positioned at an inner side of the boundary between the first region 122A and the second region 122B in plan view. In a case where the material of the superconducting film 123 is niobium, as the etchant, for example, a hydrogen fluoride (HF) solution, a mixed solution of HF and H₂O₂, a mixed solution of HF, H₂SO₄, and HNO₃, or a mixed solution of HF and HNO₃ can be used. In a case where the material of the superconducting film 123 is aluminum, for example, a diluted hydrochloric acid (HCl) solution or a diluted H₂SO₄ solution can be used as the etchant.

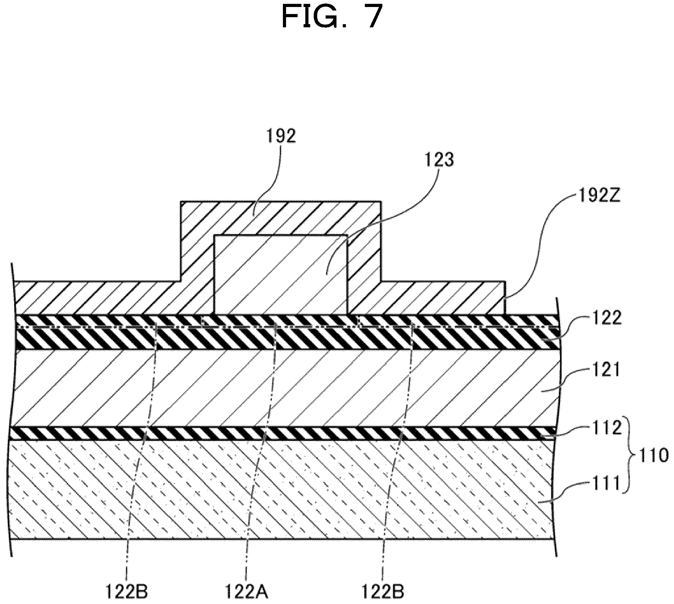

Thereafter, as illustrated in FIG. 7, a resist pattern 192 is formed over the insulating film 122 and the superconducting film 123. The resist pattern 192 includes an opening 192Z. In plan view, the opening 192Z overlaps a region where the grooves 121Z and 122Z are to be formed.

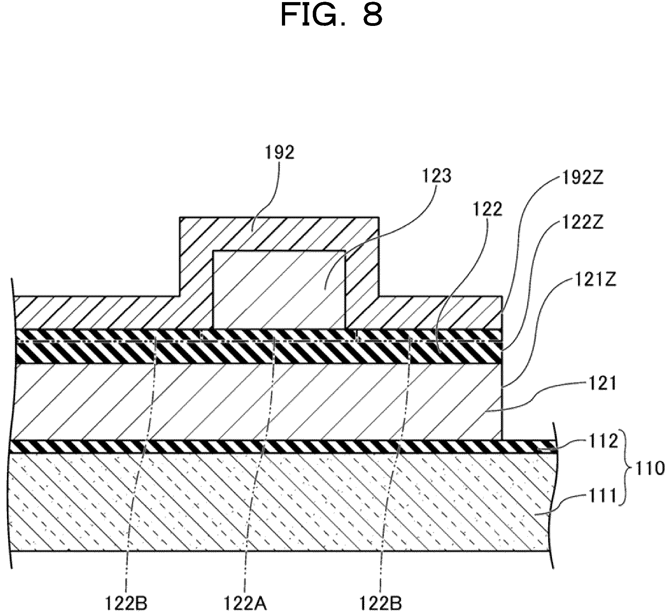

Subsequently, as illustrated in FIG. 8, the insulating film 122 is milled with the resist pattern 192 as a mask. As a result, the groove 122Z is formed in the insulating film 122. Furthermore, the superconducting film 123 is etched with the resist pattern 192 as a mask. This etching is, for example, RIE using a reactive gas containing sulfur hexafluoride as a main component. As a result, the groove 121Z is formed in the superconducting film 121.

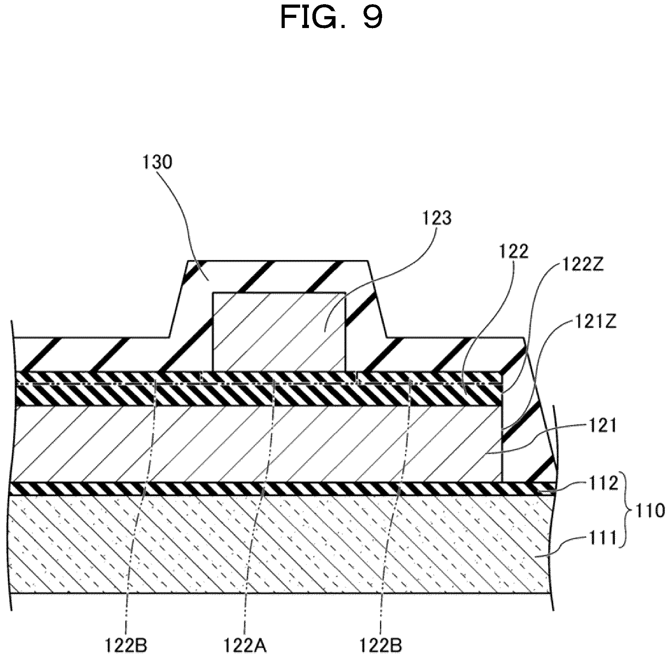

Next, as illustrated in FIG. 9, the resist pattern 192 is removed. Thereafter, the insulating film 130 covering the substrate 110, the superconducting film 121, the insulating film 122, and the superconducting film 123 is formed. The insulating film 130 is formed by, for example, a chemical vapor deposition (CVD) method.

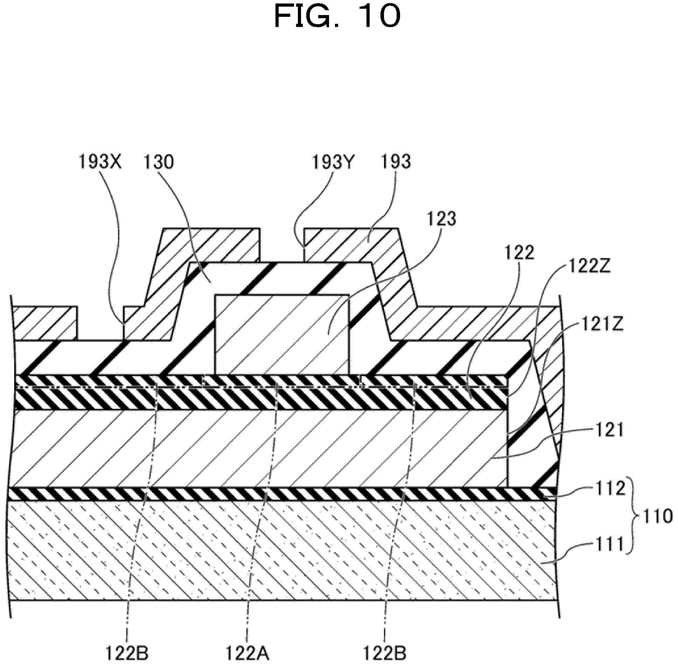

Subsequently, as illustrated in FIG. 10, a resist pattern 193 is formed over the insulating film 130. The resist pattern 193 includes openings 193X and 193Y. In plan view, the opening 193X overlaps a region where the contact holes 122X and 130X are to be formed, and the opening 193Y overlaps a region where the contact hole 130Y is to be formed.

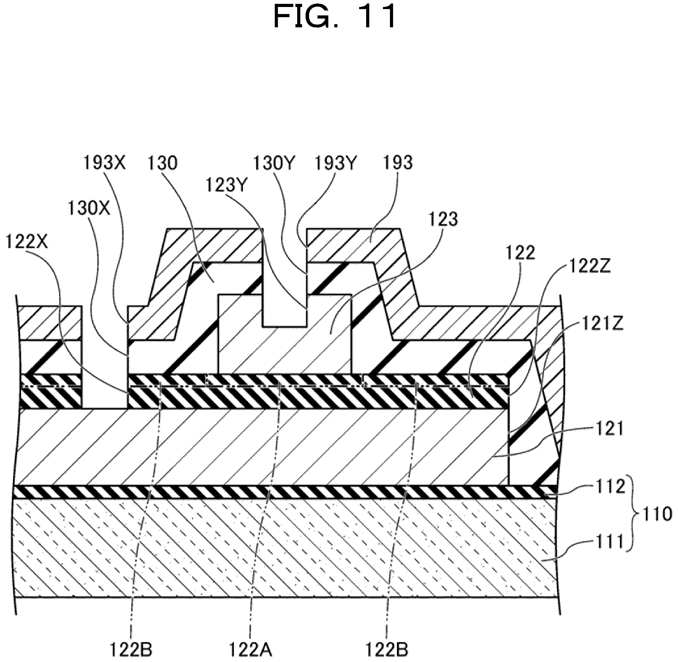

Next, as illustrated in FIG. 11, the insulating film 130 is etched with the resist pattern 193 as a mask. This etching is, for example, RIE using a reactive gas containing fluorocarbon (CF₄) as a main component. As a result, the contact holes 130X and 130Y are formed in the insulating film 130. Furthermore, the insulating film 122 is milled with the resist pattern 193 as a mask. As a result, the contact hole 130X is formed in the insulating film 122. At this time, the recess 123Y may be formed in a portion of the superconducting film 123 exposed from the contact hole 130Y.

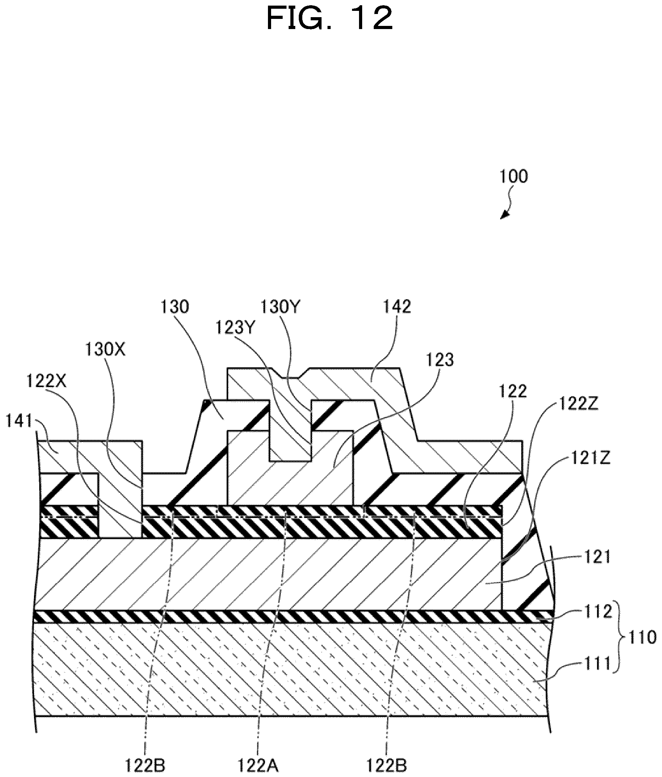

Thereafter, as illustrated in FIG. 12, the wire line 141 in contact with the superconducting film 121 through the contact holes 122X and 130X and the wire line 142 in contact with the superconducting film 123 through the contact hole 130Y are formed over the insulating film 130.

In this manner, the Josephson junction device 100 according to the first embodiment can be manufactured. Since the miniaturization of the Josephson junction device increases the proportion of a region of the superconducting film where damage has occurred, a change in properties is likely to become significant. Therefore, the present invention is particularly effective in such a case.

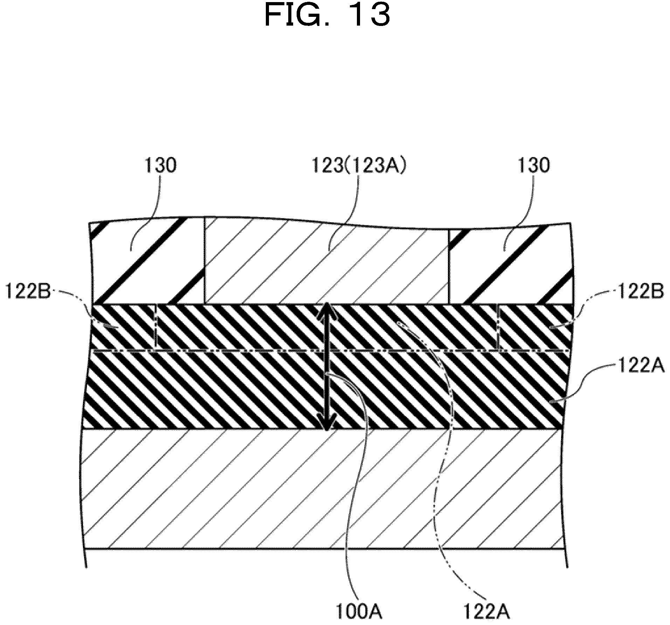

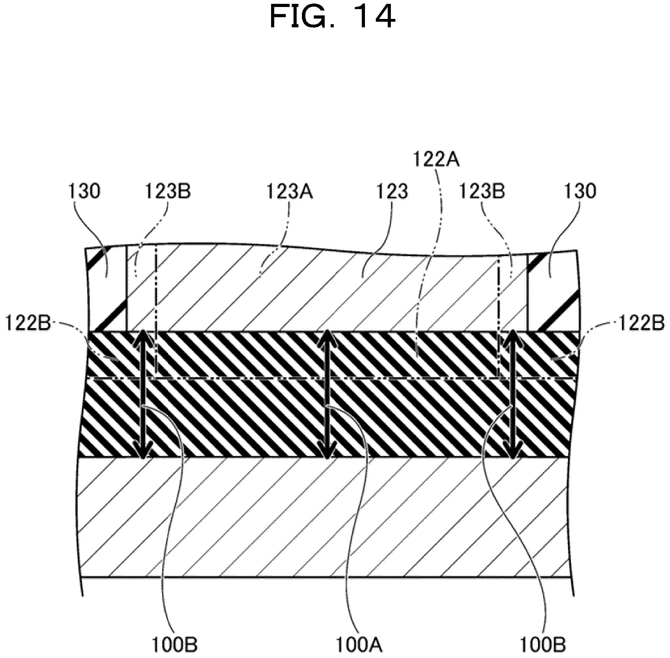

Here, effects obtained by the Josephson junction device 100 according to the first embodiment will be described in comparison with a reference example. FIG. 13 is an enlarged cross-sectional view illustrating a part of FIG. 1. FIG. 14 is a cross-sectional view illustrating a portion corresponding to the Josephson junction device in FIG. 13 according to the reference example.

As illustrated in FIG. 13, the first region 122A and the second region 122B have been produced in the surface layer portion of the insulating film 122, and damage due to the RIE (see FIG. 5) has occurred in the second region 122B, whereas damage due to the RIE has not occurred in the first region 122A. That is, in the second region 122B, greater damage than damage in the first region 122A has occurred. Then, in the first embodiment, the superconducting film 123 is located at an inner side of the boundary between the first region 122A and the second region 122B in plan view. Therefore, a Josephson junction 100A between the superconducting film 121 and the superconducting film 123 is spaced from the second region 122B. Consequently, according to the first embodiment, stable properties may be obtained.

On the other hand, as illustrated in FIG. 14, in the reference example, the superconducting film 123 includes the damaged region 123B, and the superconducting film 123 straddles the boundary between the first region 122A and the second region 122B and includes a portion outside this boundary in plan view. Between the superconducting film 121 and the superconducting film 123, there are not only the Josephson junction 100A spaced from the second region 122B, but also a Josephson junction 100B including the second region 122B. In addition, the Josephson junction 100B sometimes includes a Josephson junction between the superconducting film 121 and the damaged region 123B. Accordingly, in the reference example, the properties are easy to vary.

### (Second Embodiment)

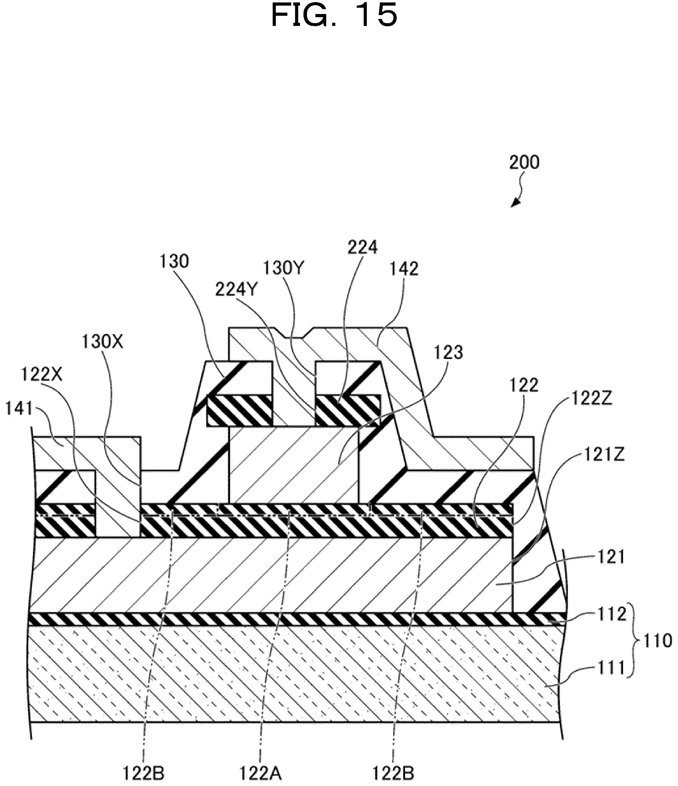

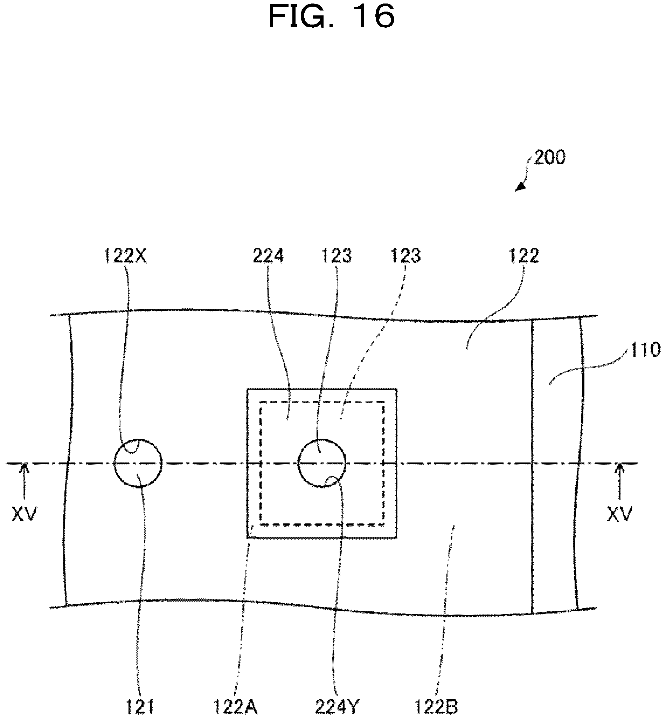

Next, a second embodiment will be described. The second embodiment relates to a Josephson junction device. FIG. 15 is a cross-sectional view illustrating a Josephson junction device according to the second embodiment. FIG. 16 is a plan view illustrating the Josephson junction device according to the second embodiment. FIG. 15 corresponds to a cross-sectional view taken along line XV-XV in FIG. 16. In FIG. 16, a wire line 141, a wire line 142, and an insulating film 130 are omitted.

As illustrated in FIGs. 15 and 16, a Josephson junction device 200 according to the second embodiment mainly includes a substrate 110, a superconducting film 121, an insulating film 122, a superconducting film 123, an insulating film 224, the insulating film 130, the wire line 141, and the wire line 142.

The insulating film 224 is provided over the superconducting film 123. The insulating film 224 is, for example, an aluminum oxide film having a thickness of about 20 nm. That is, the material of the insulating film 224 is of the same type as the type of the material of the insulating film 122, and a thickness of the insulating film 224 is equal to a thickness of the insulating film 122. The insulating film 224 is an example of a second insulating film.

The insulating film 130 covers the substrate 110, the superconducting film 121, the insulating film 122, the superconducting film 123, and the insulating film 224. The insulating film 130 is an example of a third insulating film.

A contact hole 122X is formed in the insulating film 122, and a contact hole 130X is formed in the insulating film 130. The contact hole 130X communicates with the contact hole 122X, and the superconducting film 121 is exposed through the contact holes 122X and 130X. The contact hole 122X passes through a second region 122B, for example. The wire line 141 is provided over the insulating film 130 and also is in contact with the superconducting film 121 through the contact holes 122X and 130X. The wire line 141 is an example of a first wire line. The contact holes 122X and 130X are examples of a first opening.

A contact hole 224Y is formed in the insulating film 224. A contact hole 130Y communicates with the contact hole 224Y, and the superconducting film 123 is exposed through the contact holes 224Y and 130Y. In the present embodiment, the recess 123Y is not formed on a surface of the superconducting film 123, and the surface of the superconducting film 123 is flat. The wire line 142 is provided over the insulating film 130 and also is in contact with the superconducting film 123 through the contact holes 224Y and 130Y. The wire line 142 is an example of a second wire line. The contact holes 224Y and 130Y are examples of a second opening.

Other constituent members are similar to those of the first embodiment.

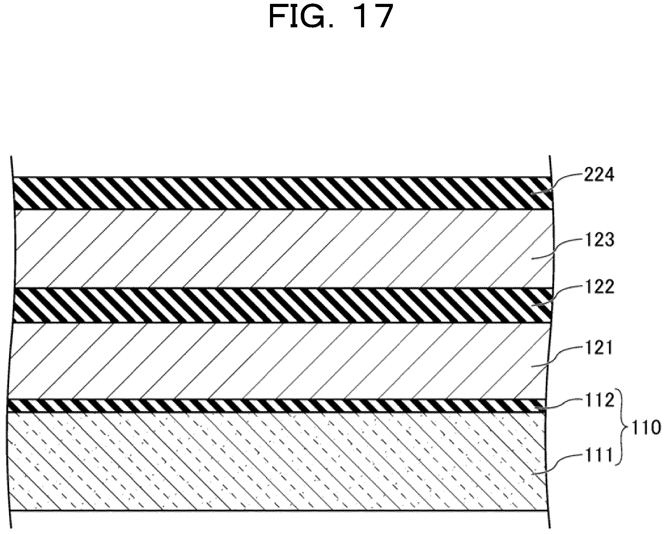

Next, a method for manufacturing the Josephson junction device 200 according to the second embodiment will be described. FIGs. 17 to 26 are cross-sectional views illustrating a method for manufacturing the Josephson junction device according to the second embodiment.

First, as illustrated in FIG. 17, the substrate 110 including a silicon substrate 111 and an insulating film 112 is prepared, and the superconducting film 121, the insulating film 122, the superconducting film 123, and the insulating film 224 are formed over the insulating film 112.

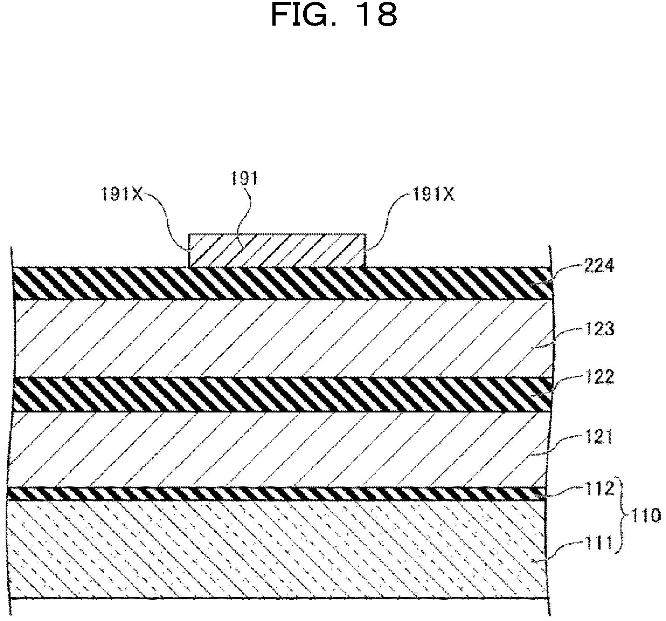

Next, as illustrated in FIG. 18, a resist pattern 191 is formed over the insulating film 224. The resist pattern 191 includes an opening 191X. In plan view, the opening 191X approximately overlaps a region where the second region 122B of the insulating film 122 is to be formed.

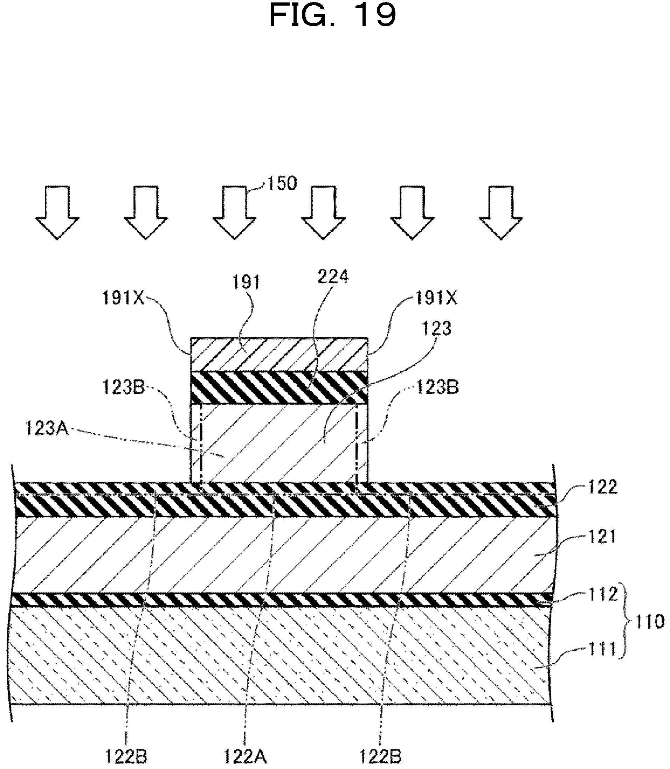

Thereafter, as illustrated in FIG. 19, the insulating film 224 is milled with the resist pattern 191 as a mask. Furthermore, similarly to the first embodiment, the superconducting film 123 is etched. As a result, a damaged region 123B is formed in the vicinity of a side surface of the superconducting film 123. The superconducting film 123 has an internal region 123A not damaged by etching on an inner side of the damaged region 123B. In addition, a first region 122A and the second region 122B around the first region 122A are formed in a surface layer portion of the insulating film 122.

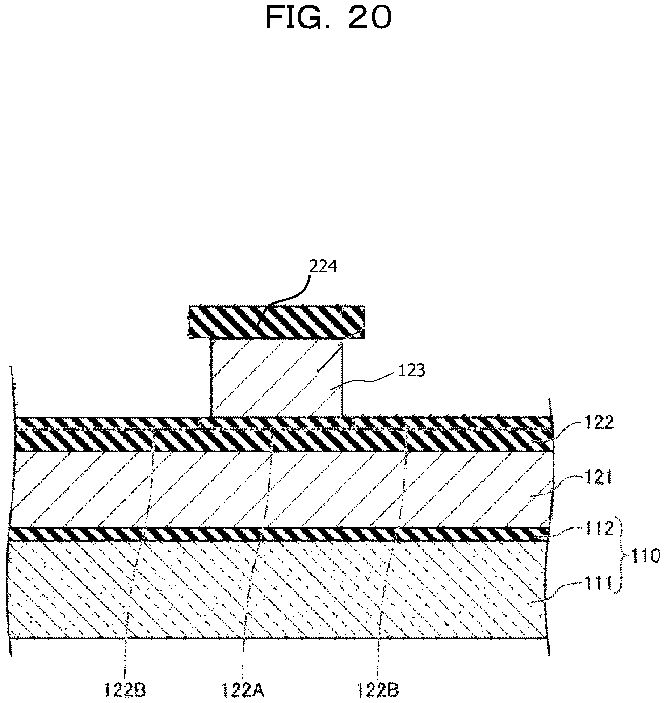

Subsequently, as illustrated in FIG. 20, the resist pattern 191 is removed. Next, similarly to the first embodiment, isotropic etching for the superconducting film 123 is performed to remove the damaged region 123B. That is, the superconducting film 123 is reduced in plan view by isotropic etching. As a result, the superconducting film 123 is positioned over the first region 122A and is positioned at an inner side of the boundary between the first region 122A and the second region 122B in plan view.

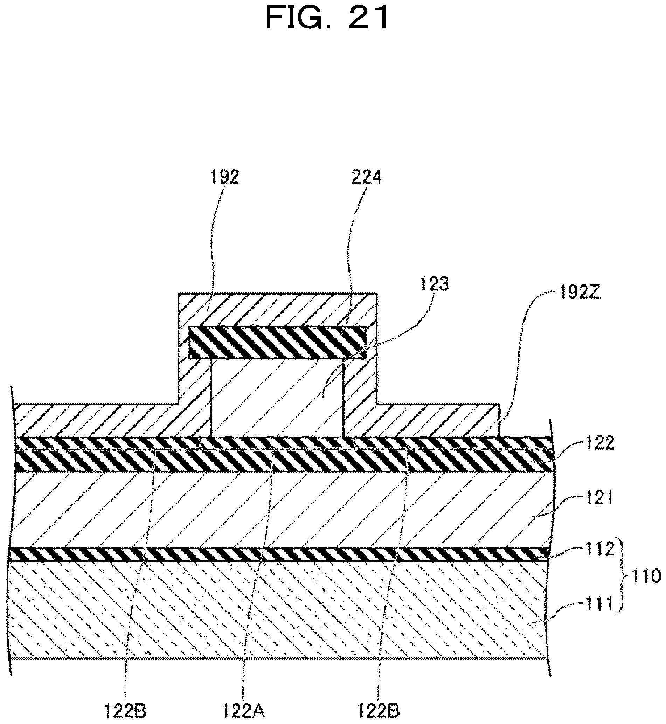

Thereafter, as illustrated in FIG. 21, a resist pattern 192 is formed over the insulating film 122, the superconducting film 123, and the insulating film 224. The resist pattern 192 includes an opening 192Z. In plan view, the opening 192Z overlaps a region where grooves 121Z and 122Z are to be formed.

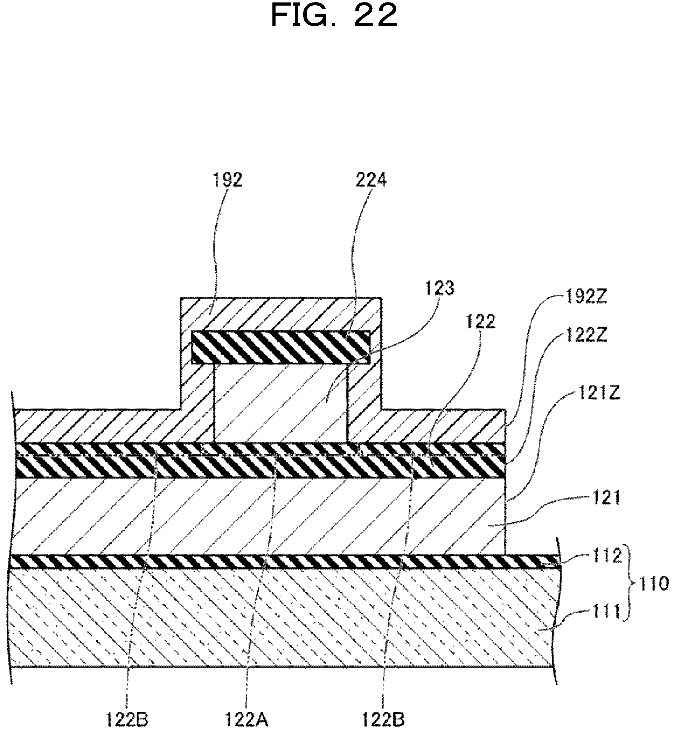

Subsequently, as illustrated in FIG. 22, the insulating film 122 is milled with the resist pattern 192 as a mask, similarly to the first embodiment. As a result, the groove 122Z is formed in the insulating film 122. Furthermore, similarly to the first embodiment, the superconducting film 123 is etched with the resist pattern 192 as a mask. As a result, the groove 121Z is formed in the superconducting film 121.

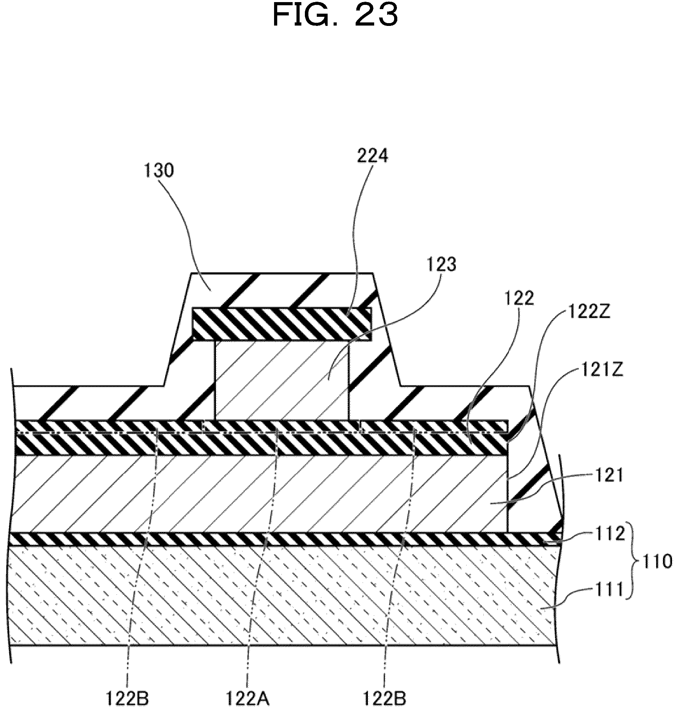

Next, as illustrated in FIG. 23, the resist pattern 192 is removed. Thereafter, the insulating film 130 covering the substrate 110, the superconducting film 121, the insulating film 122, the superconducting film 123, and the insulating film 224 is formed. The insulating film 130 is formed by, for example, the CVD method.

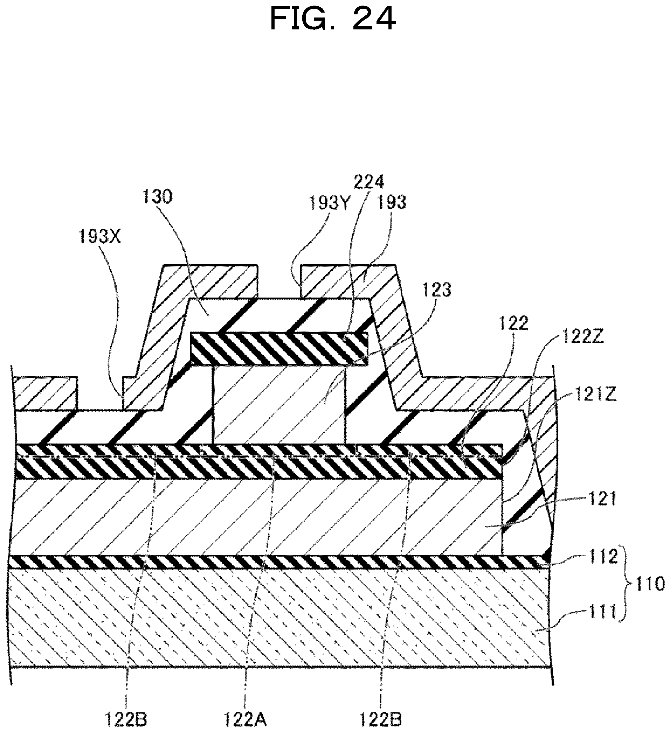

Subsequently, as illustrated in FIG. 24, a resist pattern 193 is formed over the insulating film 130, similarly to the first embodiment. The resist pattern 193 includes openings 193X and 193Y. In plan view, the opening 193X overlaps a region where the contact holes 122X and 130X are to be formed, and the opening 193Y overlaps a region where the contact holes 224Y and 130Y are to be formed.

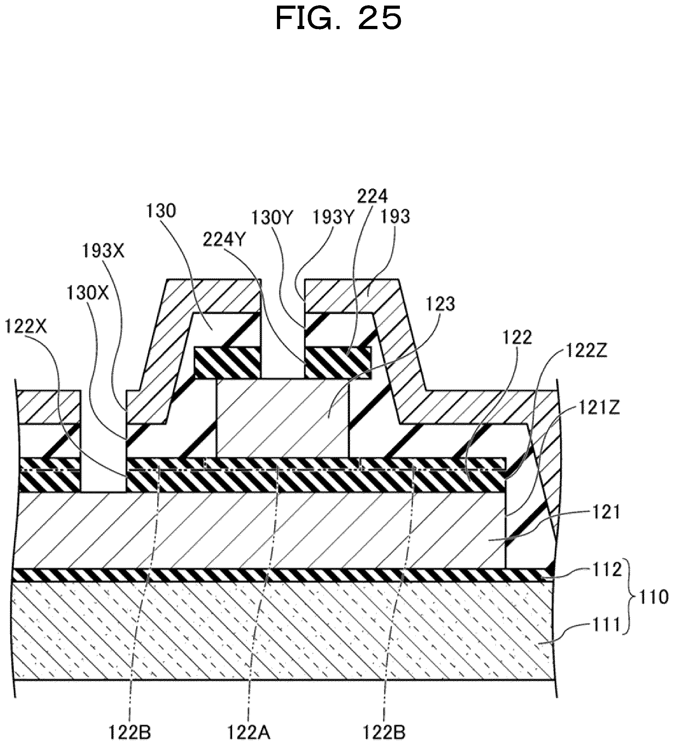

Next, as illustrated in FIG. 25, the insulating film 130 is etched with the resist pattern 193 as a mask, similarly to the first embodiment. As a result, the contact holes 130X and 130Y are formed in the insulating film 130. Furthermore, the insulating films 122 and 224 are milled with the resist pattern 193 as a mask. As a result, the contact hole 130X is formed in the insulating film 122, and the contact hole 130Y is formed in the insulating film 224. Since the material of the insulating film 224 is of the same type as the type of the material of the insulating film 122 and a thickness of the insulating film 224 is equal to a thickness of the insulating film 122, if the milling of the insulating film 122 is stopped when the superconducting film 121 is exposed, the milling of the insulating film 224 is also stopped when the superconducting film 123 is exposed.

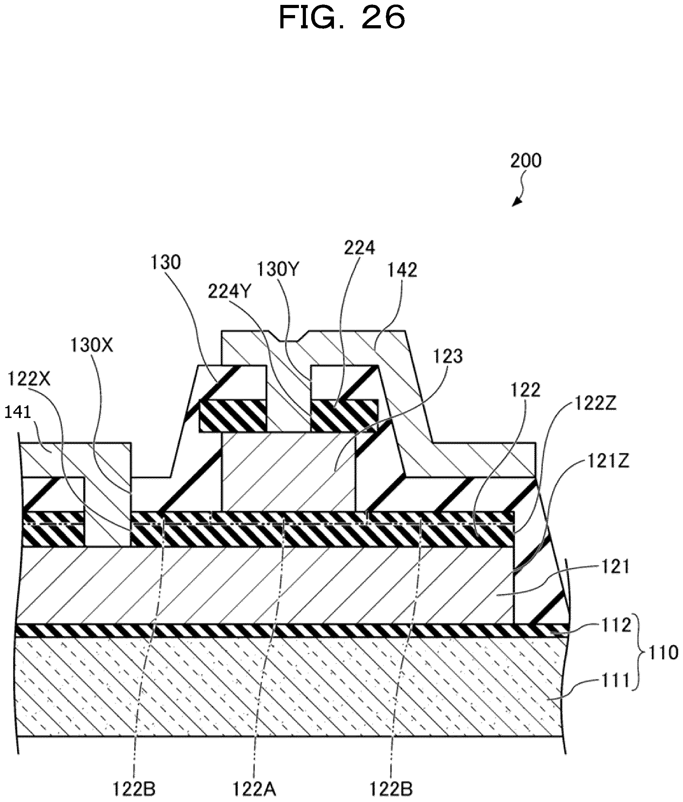

Thereafter, as illustrated in FIG. 26, the wire line 141 in contact with the superconducting film 121 through the contact holes 122X and 130X and the wire line 142 in contact with the superconducting film 123 through the contact holes 224Y and 130Y are formed over the insulating film 130.

In this manner, the Josephson junction device 200 according to the second embodiment can be manufactured.

Effects similar to those of the first embodiment may also be exerted by the second embodiment. In addition, in the second embodiment, formation of the recess 123Y on the surface of the superconducting film 123 can be suppressed. Accordingly, damage to the superconducting film 123 caused by formation of the recess 123Y may be suppressed.

Note that a thickness of the insulating film 224 preferably coincides with a thickness of the insulating film 122, but the insulating film 224 may be thicker or thinner than the insulating film 122. In addition, the material of the insulating film 224 is preferably of the same type as the type of the material of the insulating film 122, but does not necessarily have to be the same. In any case, it is desirable that deviation of end timings is small between the milling of the insulating film 224 and the milling of the insulating film 122.

The material of the superconducting films 121 and 123 is not particularly limited and may include, for example, niobium, aluminum, niobium nitride, or titanium nitride, or any combination thereof. In addition, the material of the insulating films 122 and 224 is also not particularly limited and may include aluminum oxide, aluminum nitride, hafnium oxide, or yttrium oxide, or any combination thereof.

### (Third Embodiment)

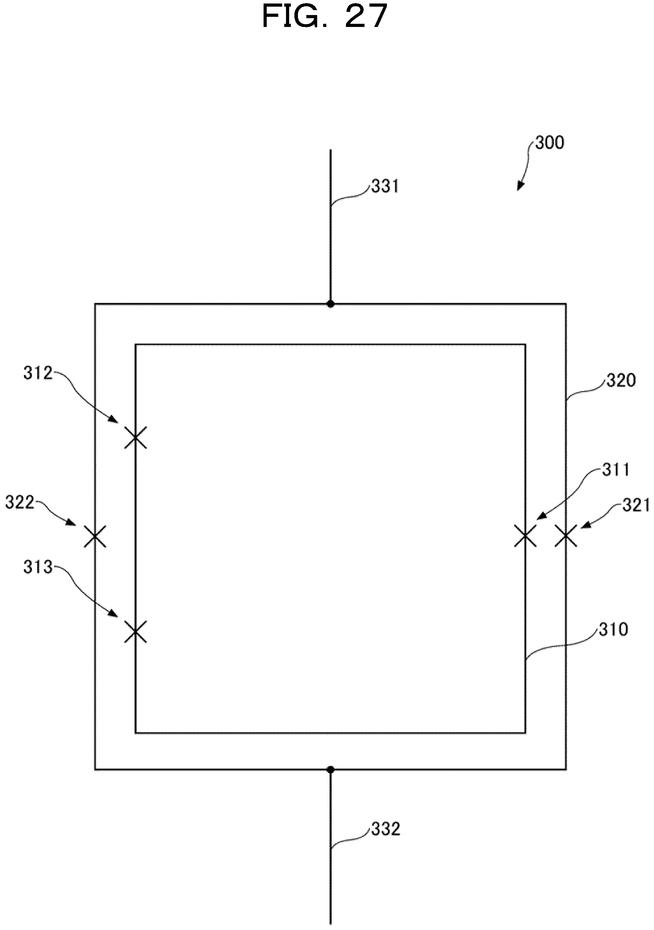

Next, a third embodiment will be described. The third embodiment relates to a quantum device. FIG. 27 is a diagram illustrating a quantum device according to the third embodiment.

A quantum device 300 according to the third embodiment includes a qubit 310, a read circuit 320, and wire lines 331 and 332. The qubit 310 includes Josephson junction devices 311, 312, and 313. The read circuit 320 includes Josephson junction devices 321 and 322. The read circuit 320 is coupled between the wire lines 331 and 332. The qubit 310 is provided at an inner side of the read circuit 320. The read circuit 320 reads the state of the qubit 310. The Josephson junction devices 311, 312, 313, 321, and 322 are constituted by the Josephson junction device 100 or 200.

Since the quantum device 300 according to the third embodiment includes the Josephson junction device 100 or 200, stable properties may be obtained. The quantum device 300 can be used for, for example, a quantum computer.

Although the preferred embodiments and the like have been described in detail so far, the embodiments are not restricted to the above-described embodiments and the like, and various modifications and substitutions can be made to the embodiments and the like described above, without departing from the scope disclosed in the claims.

### REFERENCE SIGNS LIST

100, 200, 311, 312, 313, 321, 322 Josephson junction device
121, 123 Superconducting film
122, 130, 224 Insulating film
122A First region
122B Second region
123A Internal region
123B Damaged region
123Y Recess
122X, 130X, 130Y, 224Y Contact hole
141, 142 Wire line
300 Quantum device
310 Qubit
320 Read circuit

## Claims

1. A Josephson junction device comprising:
a first superconducting film;
a first insulating film provided over the first superconducting film; and
a second superconducting film provided over the first insulating film, wherein
a surface layer portion of the first insulating film includes:
a first region; and
a second region around the first region,
electrical insulation properties of the first region are higher than the electrical insulation properties of the second region, and
the second superconducting film is located at an inner side of a boundary between the first region and the second region in plan view.

2. The Josephson junction device according to claim 1, comprising:
a second insulating film provided over the second superconducting film; and
a third insulating film that covers the first insulating film, the second superconducting film, and the second insulating film, wherein
a first opening that reaches the first superconducting film is formed in the first insulating film and the third insulating film,
a second opening that reaches the second superconducting film is formed in the second insulating film and the third insulating film, and
the Josephson junction device comprises: a first wire line coupled to the first superconducting film through the first opening; and
a second wire line coupled to the second superconducting film through the second opening.

3. The Josephson junction device according to claim 2, wherein materials of the second insulating film are of same types as the types of the materials of the first insulating film, and
a thickness of the second insulating film is equal to the thickness of the first insulating film.

4. The Josephson junction device according to claim 2 or 3, wherein the second superconducting film is located at an inner side of an outer edge of the second insulating film in plan view.

5. The Josephson junction device according to any one of claims 1 to 3, wherein materials of the first insulating film include aluminum oxide, aluminum nitride, hafnium oxide, or yttrium oxide, or any combination of the aluminum oxide, the aluminum nitride, the hafnium oxide, and the yttrium oxide.

6. The Josephson junction device according to any one of claims 1 to 3, wherein materials of the first superconducting film and the second superconducting film include niobium, aluminum, niobium nitride, or titanium nitride, or any combination of the niobium, the aluminum, the niobium nitride, and the titanium nitride.

7. A quantum device comprising:
a Josephson junction device including:
a first superconducting film;
a first insulating film provided over the first superconducting film; and
a second superconducting film provided over the first insulating film, wherein
a surface layer portion of the first insulating film includes:
a first region; and
a second region around the first region,
electrical insulation properties of the first region are higher than the electrical insulation properties of the second region, and
the second superconducting film is located at an inner side of a boundary between the first region and the second region in plan view.

8. The quantum device according to claim **7,** comprising:
a second insulating film provided over the second superconducting film; and
a third insulating film that covers the first insulating film, the second superconducting film, and the second insulating film, wherein
a first opening that reaches the first superconducting film is formed in the first insulating film and the third insulating film,
a second opening that reaches the second superconducting film is formed in the second insulating film and the third insulating film, and
the Josephson junction device comprises: a first wire line coupled to the first superconducting film through the first opening; and
a second wire line coupled to the second superconducting film through the second opening.

9. The quantum device according to claim 8, wherein materials of the second insulating film are of same types as the types of the materials of the first insulating film, and
a thickness of the second insulating film is equal to the thickness of the first insulating film.

10. The quantum device according to claim 8 or 9, wherein the second superconducting film is located at an inner side of an outer edge of the second insulating film in plan view.

11. The quantum device according to any one of claims 7 to 9, wherein materials of the first insulating film include aluminum oxide, aluminum nitride, hafnium oxide, or yttrium oxide, or any combination of the aluminum oxide, the aluminum nitride, the hafnium oxide, and the yttrium oxide.

12. The quantum device according to any one of claims 7 to 9, wherein materials of the first superconducting film and the second superconducting film include niobium, aluminum, niobium nitride, or titanium nitride, or any combination of the niobium, the aluminum, the niobium nitride, and the titanium nitride.

13. A method for manufacturing a Josephson junction device, comprising:
providing a first insulating film over a first superconducting film;
providing a second superconducting film over the first insulating film;
processing the second superconducting film by reactive ion etching; and
etching a sidewall of the processed second superconducting film.

14. The method for manufacturing the Josephson junction device according to claim 13, comprising:
between the providing the second superconducting film and the processing the second superconducting film,
providing a second insulating film over the second superconducting film; and
processing the second insulating film, and
comprising:
after the etching the sidewall of the second superconducting film,
providing a third insulating film that covers the first insulating film, the second superconducting film, and the second insulating film;
forming a first opening that reaches the first superconducting film, in the first insulating film and the third insulating film, and forming a second opening that reaches the second superconducting film, in the second insulating film and the third insulating film; and
providing a first wire line coupled to the first superconducting film through the first opening, and a second wire line coupled to the second superconducting film through the second opening.
